# EUROPEAN PATENT SPECIFICATION

(11) **EP 3 059 605 B1**
(45) Date of publication and mention of the grant of the patent: **25.12.2019**
(21) Application number: 16153045.6
(22) Date of filing: 28.01.2016
(51) Int. Cl.: G01S 5/16, G01S 5/02

(54) **A 3D MODELLING SYSTEM**
3D-MODELLIERUNGSSYSTEM
SYSTÈME DE MODÉLISATION 3D

(30) Priority: 16.02.2015 GB 201502526
(43) Date of publication of application: 24.08.2016
(73) Proprietor: Nokia Technologies Oy, 02610 Espoo (FI)
(72) Inventor: LEPPÄNEN, Jussi, 33580 Tampere (FI); ERONEN, Antti, 33820 Tampere (FI); LEHTINIEMI, Arto, 33880 Lempäälä (FI); ROIMELA, Kimmo, 33710 Tampere (FI)
(74) Representative: Berggren Oy, Tampere

(56) References cited:
- US-A1- 2004 164 858
- US-A1- 2011 135 149
- US-A1- 2015 023 562

## Description

### Field

The invention relates to positioning of devices, and more particularly to a three-dimensional (3D) modelling system used in localizing devices.

### Background

Modern building automation, such as home or factory automation, may involve a plurality of uniquely identifiable devices, such as IoT (Internet of Things) devices. IoT devices are uniquely identifiable embedded computing devices, which are provided with an IP address and are interconnectable within the existing Internet infrastructure.

For enabling enhanced interaction and/or control of such uniquely identifiable devices, it may be required that the location of these devices in the actual space is determined. It may be advantageous to create a three-dimensional (3D) model of the space and map the uniquely identifiable devices to the corresponding locations in the 3D model.

However, it is not a trivial task to match the uniquely identifiable devices to objects in the 3D map of the space. The uniquely identifiable devices and their corresponding objects in the 3D model need to be visually recognized, but it is computationally very intensive to search all devices in a brute force manner, for example to perform image matching for every device and for every keyframe of a video used for creating the 3D model.

Therefore, there is a need for a more optimised procedure for matching devices to a 3D model A system and method for tracking objects is known from US 2011/0135149 A1.

### Summary

Now there has been invented an improved method and technical equipment implementing the method for at least alleviating the problems. Various aspects of the invention include a method, an apparatus and a computer program, which are characterized by what is stated in the independent claims. Various embodiments of the invention are disclosed in the dependent claims. According to a first aspect, there is provided a method comprising: obtaining a three-dimensional (3D) model of a space; obtaining relative positions of a plurality of uniquely identifiable devices in said space; mapping a first uniquely identifiable device to a first visually matching object in the 3D model; selecting a second uniquely identifiable device; determining possible locations of the second uniquely identifiable device in said space on the basis of the relative distance between the first and second uniquely identifiable device; and mapping the second uniquely identifiable device to a second visually matching object in the 3D model, said second object locating in one of said possible locations.

According to an embodiment, the method further comprises selecting a third uniquely identifiable device; determining possible locations of the third uniquely identifiable device in said space on the basis of the relative distances between the first, second and third uniquely identifiable device; and mapping the third uniquely identifiable device to a third visually matching object in the 3D model, said third object locating in one of said possible locations.

According to an embodiment, said relative positions of the plurality of uniquely identifiable devices are determined in a substantially two-dimensional (2D) plane, wherein possible locations of the third uniquely identifiable device in said space comprises two possible locations, the method further comprising selecting one of said two possible locations mapping the third uniquely identifiable device to the third object in the 3D model.

According to an embodiment, the method further comprises mapping any subsequent uniquely identifiable device to a visually matching object in the 3D model on the basis of the relative distances of said subsequent uniquely identifiable device to the first, second and third uniquely identifiable device. According to an embodiment, obtaining the 3D model of the space comprises capturing a plurality of images or video frames about the space; and generating a 3D point cloud describing shapes of a plurality of objects in the space.

According to an embodiment, said uniquely identifiable devices are provided with a radio transmitter and a unique identification, wherein obtaining relative positions of the uniquely identifiable devices comprises determining said relative positions on the basis of radio signal strengths of the devices.

According to an embodiment, the method further comprises selecting the first uniquely identifiable device from said images or video frames using an object recognition algorithm, wherein the selecting is performed on the basis of distinctiveness of volume or visual characteristics of the device.

According to an embodiment, the method further comprises obtaining the unique identification of the first device; and determining properties of the first device from a server comprising device parameters associated with the unique identification.

According to an embodiment, the method further comprises performing a visual object recognition process on a subset of said plurality of images or video frames for finding the first device; and mapping the position of the first device to the 3D model based on a camera pose of one or more images or video frames where the first device was found.

According to a second aspect, there is provided an apparatus comprising at least one processor, memory including computer program code, the memory and the computer program code configured to, with the at least one processor, cause the apparatus to at least:
obtain a three-dimensional (3D) model of a space;
obtain relative positions of a plurality of uniquely identifiable devices in said space;
map a first uniquely identifiable device to a first visually matching object in the 3D model;
select a second uniquely identifiable device;
determine possible locations of the second uniquely identifiable device in said space on the basis of relative distance between the first and second uniquely identifiable device; and
map the second uniquely identifiable device to a second visually matching object in the 3D model, said second object locating in one of said possible locations.

These and other aspects of the invention and the embodiments related thereto will become apparent in view of the detailed disclosure of the embodiments further below.

### List of drawings

In the following, various embodiments of the invention will be described in more detail with reference to the appended drawings, in which
- Figs. 1a and 1b: show a system and devices suitable to be used in a 3D modelling system according to an embodiment;
- Fig. 2: shows a flow chart of a 3D modelling method according to an embodiment;
- Fig. 3: shows an example of a room comprising a plurality of uniquely identifiable devices;
- Fig. 4: shows the room of Figure 3 as the 3D representation of the room and the relative positions of the plurality of uniquely identifiable devices separated;
- Fig. 5: shows the room of Figure 3, where the first device has been positioned and possible locations of the other devices has been determined according to an embodiment;
- Fig. 6: shows the room of Figure 3, where the first and the second devices have been positioned and possible locations of the third devices has been determined according to an embodiment; and
- Fig. 7: shows the room of Figure 3, where all devices have been positioned according to an embodiment.

### Description of embodiments

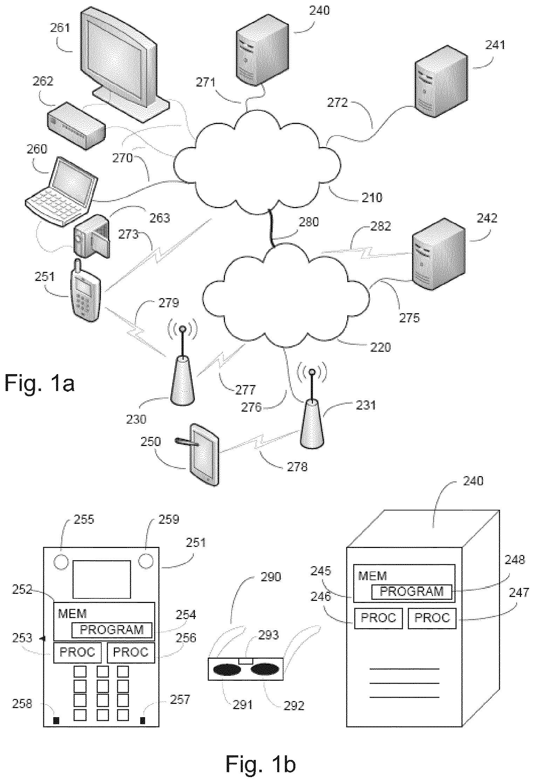

Figs. 1a and 1b show a system and devices suitable to be used in a 3D modelling system according to an embodiment. In Fig. 1a, the different devices may be connected via a fixed network 210 such as the Internet or a local area network; or a mobile communication network 220 such as the Global System for Mobile communications (GSM) network, 3rd Generation (3G) network, 3.5th Generation (3.5G) network, 4th Generation (4G) network, Wireless Local Area Network (WLAN), Bluetooth®, or other contemporary and future networks. Different networks are connected to each other by means of a communication interface 280. The networks comprise network elements such as routers and switches to handle data (not shown), and communication interfaces such as the base stations 230 and 231 in order for providing access for the different devices to the network, and the base stations 230, 231 are themselves connected to the mobile network 220 via a fixed connection 276 or a wireless connection 277.

There may be a number of servers connected to the network, and in the example of Fig. 1a are shown servers 240, 241 and 242, each connected to the mobile network 220, which servers may be arranged to operate as computing nodes (i.e. to form a cluster of computing nodes or a so-called server farm) for the system. Some of the above devices, for example the computers 240, 241, 242 may be such that they are arranged to make up a connection to the Internet with the communication elements residing in the fixed network 210.

There are also a number of end-user devices such as mobile phones and smart phones 251, Internet access devices (Internet tablets) 250, personal computers 260 of various sizes and formats, televisions and other viewing devices 261, video decoders and players 262, as well as video cameras 263 and other encoders. These devices 250, 251, 260, 261, 262 and 263 can also be made of multiple parts. The various devices may be connected to the networks 210 and 220 via communication connections such as a fixed connection 270, 271, 272 and 280 to the internet, a wireless connection 273 to the internet 210, a fixed connection 275 to the mobile network 220, and a wireless connection 278, 279 and 282 to the mobile network 220. The connections 271-282 are implemented by means of communication interfaces at the respective ends of the communication connection.

Fig. 1b shows devices for a 3D modelling system according to an example embodiment. As shown in Fig. 1b, the server 240 contains memory 245, one or more processors 246, 247, and computer program code 248 residing in the memory 245 for implementing, for example, a web service system. The different servers 241, 242, 290 may contain at least these elements for employing functionality relevant to each server.

Similarly, the end-user device 251 contains memory 252, at least one processor 253 and 256, and computer program code 254 residing in the memory 252 for implementing, for example, gesture recognition. The end-user device may also have one or more cameras 255 and 259 for capturing image data, for example stereo video. The end-user device may also contain one, two or more microphones 257 and 258 for capturing sound. The different end-user devices 250, 260 may contain at least these same elements for employing functionality relevant to each device.

The end user devices may also comprise a screen for viewing single-view, stereoscopic (2-view), or multiview (more-than-2-view) images. The end-user devices may also be connected to video glasses 290 e.g. by means of a communication block 293 able to receive and/or transmit information. The glasses may contain separate eye elements 291 and 292 for the left and right eye.

It needs to be understood that different embodiments allow different parts to be carried out in different elements. For example, parallelized processes of the 3D modelling system may be carried out in one or more network devices 240, 241, 242, 290. The elements of the 3D modelling system may be implemented as a software component residing on one device or distributed across several devices, as mentioned above, for example so that the devices form a so-called cloud.

The Internet of Things (IoT) may be defined, for example, as an interconnection of uniquely identifiable embedded computing devices within the existing Internet infrastructure. The convergence of various technologies has and will enable many fields of embedded systems, such as wireless sensor networks, control systems, home/building automation, etc. to be included the Internet of Things (IoT). In order to utilize Internet IoT devices are provided with an IP address as a unique identifier. IoT devices may be provided with a radio transmitter, such as WLAN or Bluetooth transmitter or a RFID tag. Alternatively, IoT devices may have access to an IP-based network via a wired network, such as an Ethernet-based network or a power-line connection (PLC).

Modern building automation, such as home or factory automation, may involve a plurality of uniquely identifiable devices, and IoT devices are mentioned here only as examples of uniquely identifiable devices. For enabling enhanced interaction and/or control of such uniquely identifiable devices, the location of these devices in the actual space should be determined. It may be advantageous to create a three-dimensional (3D) model of the space and map the uniquely identifiable devices to the corresponding locations in the 3D model.

Considering, for example, a home automation related task of localizing uniquely identifiable devices, such as various home entertainment equipment, to correct places on a 3D model of a person's house. A 3D model of a room, for example, may be obtained using any known technology, such as Structure-From-Motion. It is also possible to obtain relative positions between loT devices using Bluetooth positioning, for example. However, it is not a trivial task to match the relative positions of the IoT devices to the 3D map of the room. The uniquely identifiable devices and their corresponding objects in the 3D model need to be visually recognized, but it is computationally very intensive to search all devices in a brute force manner, i.e. perform image matching for every device and for every keyframe of a video used for creating the 3D model.

In order to alleviate these problems, a new method for matching devices to a 3D model is presented herein. The method is based on the idea of using radio signal positioning to obtain relative positions of devices and then using the relative positions when visually matching the devices to a 3D model.

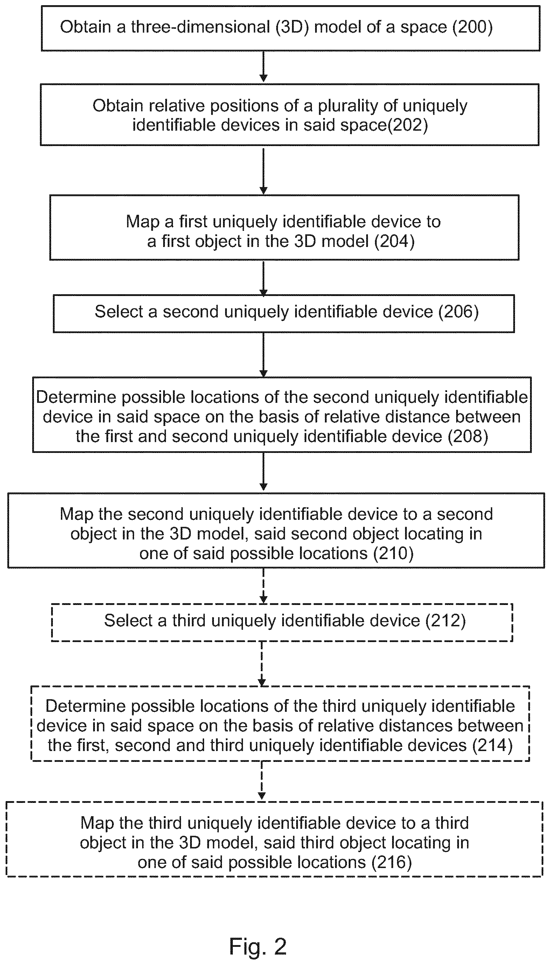

A method according to a first aspect and various embodiments related thereto are now described by referring to the flow chart of Figure 2 describing the operation of the 3D modelling system.

In the method, a three-dimensional (3D) model of a space is obtained (200). The space may comprise a plurality of uniquely identifiable devices, and relative positions of the plurality of uniquely identifiable devices in said space are obtained (202). A first uniquely identifiable device is mapped (204) to a first object in the 3D model. Then, from the plurality of uniquely identifiable devices in said space, a second uniquely identifiable device is selected (206). Possible locations of the second uniquely identifiable device in said space are determined (208) on the basis of relative distance between the first and second uniquely identifiable device, and the second uniquely identifiable device is mapped (210) to a second object in the 3D model, said second object locating in one of said possible locations.

Hence, the method enables to quickly and accurately match the devices to a 3D model by obtaining relative positions of the devices and then using the relative positions when visually matching the devices to a 3D model. The information about the relative positions and mutual distances between the devices poses constraints on the locations and the geometry where the matching is performed.

If the space comprises only two uniquely identifiable devices, after identifying the first device and mapping it to the 3D model, the above method facilitates and expedites finding and mapping the second device significantly, since the known relative distance between the first and second device reduces the degree-of-freedom for the possible locations of the second uniquely identifiable device. As a result, the search of the second device may be focused only on devices locating at said distance from the first device.

Moreover, if the space comprises more than two uniquely identifiable devices, the above method provides an excellent starting point for finding and mapping any subsequent devices, since it further reduces the degree-of-freedom for the possible locations of a third uniquely identifiable device.

According to an embodiment, the method further comprises selecting (212) a third uniquely identifiable device, determining (214) possible locations of the third uniquely identifiable device in said space on the basis of relative distances between the first, second and third uniquely identifiable device, and mapping (216) the third uniquely identifiable device to a third object in the 3D model, said third object locating in one of said possible locations. In Figure 2, these optional features are illustrated by dotted line.

Considering the above embodiments in a 3D space, for example in a room, after selecting and locating the first device in said space, the possible locations of the second uniquely identifiable device are defined by a sphere having a radius equal to the relative distance between the first and the second device. After mapping the second device to the 3D space, the possible locations of the third uniquely identifiable device are defined by an arc of a circle where the relative distance between the first and the third device, and the relative distance between the second and third device, respectively, remain constant. Thus, the degree-of-freedom for the possible locations of a third uniquely identifiable device is even further reduced.

However, in most of the practical implementations the mapping can be simplified by the presumption that the camera pose is in most cases not very far from the horizontal plane and the devices are typically substantially at the level of the camera capturer.

Therefore, in most cases an embodiment can be applied, according to which said relative positions of the plurality of uniquely identifiable devices are determined in a substantially two-dimensional (2D) plane, wherein possible locations of the third uniquely identifiable device in said space comprises two possible locations, and the method further comprises selecting one of said two possible locations for mapping the third uniquely identifiable device to the third object in the 3D model.

Considering a virtual line between the first and the second device, there are now two possible locations, mirrored by said line, for the third device. In such case, mapping the third uniquely identifiable device to an appropriate object in the 3D model is significantly facilitated by the fact that visual matching needs to be performed only on those keyframes and in a region which corresponds to said two locations.

According to an embodiment, the method further comprises mapping any subsequent uniquely identifiable device to a corresponding object in the 3D model on the basis of the relative distances of said subsequent uniquely identifiable device to the first, second and third uniquely identifiable device.

Hence, after having mapped three uniquely identifiable devices to appropriate objects in the 3D model, any subsequent uniquely identifiable device can be easily mapped to its corresponding object on the basis of its distances to the three already mapped devices. It is to be noted that in case where the uniquely identifiable devices are not determined in a substantially 2D plane, but rather in 3D space, there are two possible locations for the fourth device, said two locations being mirrored by a 2D plane formed by the three already mapped devices. However, also in such case, mapping the fourth uniquely identifiable device to an appropriate object in the 3D model is typically a trivial task. After having locked the locations of the three (or four) uniquely identifiable devices, any subsequent uniquely identifiable device may only have one possible location.

The embodiments described herein may be carried out by a 3D modeling system, which may implemented in any suitable data processing device, such as any of the devices depicted in Figures 1a and 1b. For example, the 3D modeling system may be implemented in a cloud server, which receives the relative positions of devices to be localized, a 3D model, and visual content used while constructing the model as inputs, and then matches the devices to the 3D model.

According to an embodiment, obtaining the 3D model of the space comprises capturing a plurality of images or video frames about the space, and generating a 3D point cloud describing shapes of a plurality of objects in the space. Herein, if images are captured from a plurality of locations from inside the space, for example a Structure-From-Motion (SFM) system may be utilised, where three-dimensional structures are estimated from two-dimensional image sequences, where the observer and/or the objects to be observed move in relation to each other. The obtained geometric models are stored as 3D point clouds describing the shape of the space.The 3D point cloud may be further converted into a polygon mesh or a voxel representation for facilitating the processing of data in 3D computer graphics.

Naturally, any other method for generating 3D models may be used herein. For example, 3D geometry can also be measured more directly with Light Detection And Ranging (LiDAR) method, where distances are measured by illuminating an object with a laser beam (e.g. ultraviolet, visible, or near-infrared light) and analyzing the reflected light. The resulting data is stored as point clouds. Another method is based on infrared time-of-flight imaging, such as in Microsoft® Kinect. In certain occasions, such as when generating a 3D model about a room, rather simple tools may be used for creating 3D models, such as software typically used for interior design.

According to an embodiment, the uniquely identifiable devices are provided with a radio transmitter and a unique identification, wherein obtaining relative positions of the uniquely identifiable devices comprises determining said relative positions on the basis of radio signal strengths of the devices. As discussed above, for example IoT devices may be provided with a radio transmitter, such as WLAN or Bluetooth transmitter or a RFID tag, and a unique IP address. A variety of methods has been developed for estimating node positions using RF signals. These methods may be based on estimating distances between the nodes e.g. on the basis of Received Signal Strength Indicator (RSSI) and/or various time-of-flight (ToF) measurements and estimating the angles between the nodes e.g. on the basis of antenna arrays and/or Angle of Arrival (AoA) estimation techniques. Also various methods have been developed to compensate for possible propagation delays and reflections, especially in indoor measurement, such as the use of dual frequency signals for the measurement.

It is, however, to be noted that the embodiments are not limited to loT devices, but the embodiments may be applied to any uniquely identifiable devices capable of providing any unique identification, such as a device ID number, to be obtained by another device.

According to an embodiment, the first uniquely identifiable device is selected from said images or video frames using an object recognition algorithm, wherein the selecting is performed on the basis of distinctiveness of volume or visual characteristics of the device. The aim is to pick a device from the group of uniquely identifiable devices that is the easiest to find from the video feed using object recognition and/or image matching algorithms. Large devices and devices that are most likely fully visible, such as a TV, may be preferred. For example, the device with the largest volume may be picked as the first device.

According to an embodiment, the method further comprises obtaining the unique identification of the first device, and determining properties of the first device from a server comprising device parameters associated with the unique identification. Herein, the unique identification, such as an IP address or a device ID number, may be obtained e.g. from the RF signal submitted by the first device. The unique identification may be used to find the device parameters from a server connected to the system. The server may contain, in addition to the device parameters associated with the unique identification, also one or more images of the device that can be used for image matching purposes. Alternatively, the first device may provide the system with a link to a web page of a manufacturer or a store containing information about the device.

According to an embodiment, the method further comprises performing a visual object recognition process on a subset of said plurality of images or video frames for finding the first device, and mapping the position of the first device to the 3D model based on a camera pose of one or more images or video frames where the first device was found.

Various methods for object recognition from images and video have been proposed. The two main categories of approaches include appearance-based methods, which perform recognition using example images (templates or exemplars for performing recognition), and feature based approaches. In the feature based approaches, common features include, for example, the scale-invariant feature transform (SIFT) or speeded up robust features (SURF). However, any suitable visual features or their combinations such as histograms of oriented gradients (HOG) or color histograms could be used herein.

According to an embodiment, after selecting the second, and respectively the third, uniquely identifiable device and determining their possible locations, one or more of the above steps of selecting devices, obtaining their unique identifications and properties, performing the visual object recognition process and mapping their position to the 3D model may be carried out for the second, and respectively, for the third uniquely identifiable device.

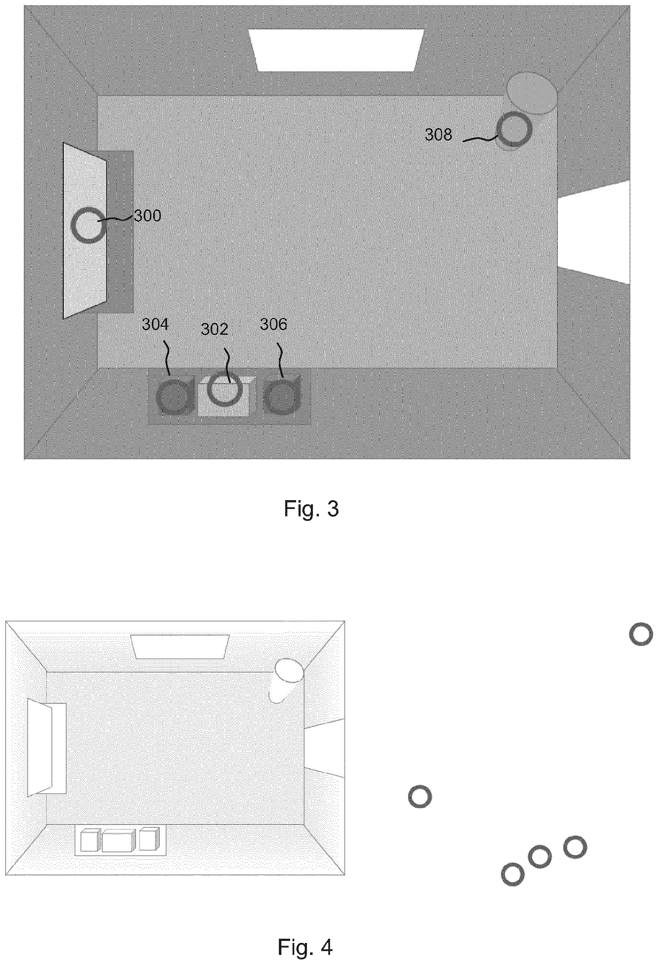

Various embodiments are now further illustrated by referring to an example shown in Figures 3 - 7. In the example, a TV set 300, a stereo system 302 with two loudspeakers 304, 306 and a humidifier 308 are located in a room. Figure 3 shows the room viewed from the top and the positions of the devices shown as circles.

First, a 3D model of the room and its interior is obtained, e.g. using any of the above-mentioned methods. Then the relative positions of the devices 300 - 308 are obtained, for example using radio signal strength relative positioning techniques. In Figure 4, the 3D representation of the room and the relative positions of the devices 300 - 308 are shown separately. The obtained positions are relative with respect to each other, and therefore there are several degrees-of-freedom regarding the actual position; for example, it cannot be determined yet whether there is any offset (in horizontal and vertical dimensions), rotation or flip of the relative positions of the device relating to the actual positions.

From the devices 300 - 308, a first device is selected. Herein, the most distinguishable device from the set of devices may be searched. The images or video frames used for creating the 3D model may be analyzed for finding the most distinguishable device. In addition or alternatively, reference images about the devices may be searched on the basis of device IDs and the reference images may utilized in the search of the most distinguishable device. In this example, the largest device, i.e. the TV set, is selected as the first device.

If any reference image about the TV set is available, a SIFT feature extraction may be performed on the reference images of the TV set. Then SIFT feature extraction may be performed for a plurality of images or video keyframes, where the plurality of images or video keyframes may be a subset of images or video frames which were used when creating the 3D model. Then the SIFT features of the TV set are compared to the SIFT features of regions of the images or the video keyframes, and if a similarity according to a predefined threshold is found, a match is declared, i.e. the SIFT features of the regions of the images or the video keyframes are recognized to belong to the TV set. If no similarity according to a predefined threshold is found, the second largest device may be searched and the above steps may be repeated until a match is found.

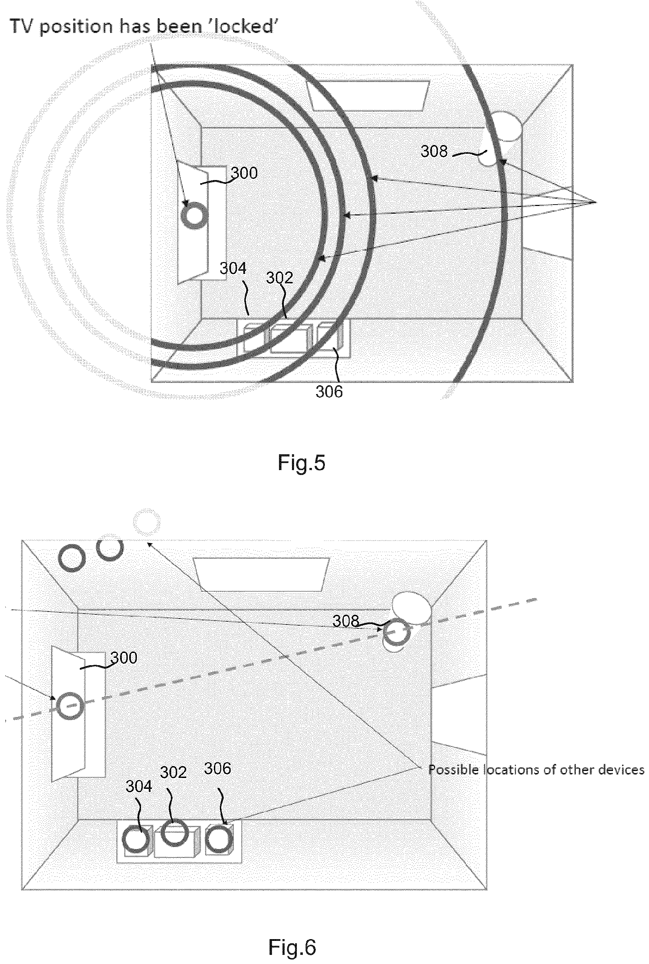

In this example, the TV set 300 is identified from the plurality of images or video keyframes, and the position of the TV set is locked to the identified object in the 3D model. Presuming that both the camera pose and the devices 300 - 308 in this example are substantially in a horizontal plane and considering that the relative positions of the devices 300 - 308 in respect to each other are known, Figure 5 shows the possible locations of the other devices once the position of the TV set has been locked. Since the distance between the TV set and each of the other devices can be defined, the possible locations of the remaining devices 302 - 308 may be illustrated by arcs of circles having radius corresponding to said distance.

Next, a second device is selected from the remaining devices 302 - 308, where again the most distinguishable device from the set of devices may be searched. In this example, the humidifier 308 is selected as the second device. The SIFT feature extraction may be performed on the reference images of the humidifier 308, and the distance between the TV set 300 and the humidifier 308 is defined.

In order to expedite finding and mapping the second device, camera pose information, such as location and orientation of capture device, for the keyframes of the video sequence used to create the 3D model may be obtained for focusing the search to relevant keyframes. Then for each of the keyframes, it may be determined whether a line defined by the camera pose intersects with the arc of circle defining the possible locations of the humidifier. Since the possible locations of the second device are significantly limited by the above condition, the humidifier 308 can be easily identified from the plurality of images or video keyframes, and the position of the humidifier is locked to the identified object in the 3D model.

Now when the positions of the TV set 300 and the humidifier 308 have been locked to the corresponding objects in the 3D model, a third device has only two possible locations mirrored by a virtual line between the TV set 300 and the humidifier 308, as shown in Figure 6. In this example, it can be seen that the other possible location of the loudspeaker 306 would reside outside the room. Thus, it can be concluded that the loudspeaker 306 has only one possible location and an object in the 3D model corresponding to the loudspeaker 306 may be searched in keyframes having the camera pose directed to that location. After identifying the object in the 3D model, the position of the loudspeaker 306 can be locked therein.

On the other hand, if it is determined that the stereo system 302 is a more prominent device to be searched in the 3D model, then for the two possible locations those video keyframes based on their camera pose information may be determined, which capture the possible locations of the third device. This may be carried out by calculating the shortest distance from the possible device locations to the line defined by each video frame camera pose. If the distance is below a threshold, say 1m, the keyframe is selected for matching process. The SIFT features of the third device are compared to the SIFT features of said video keyframes. If a sufficient similarity is found, a match is declared, but if no similarity according to a predefined threshold is found, the next largest device may be searched and the above steps may be repeated until a match is found.

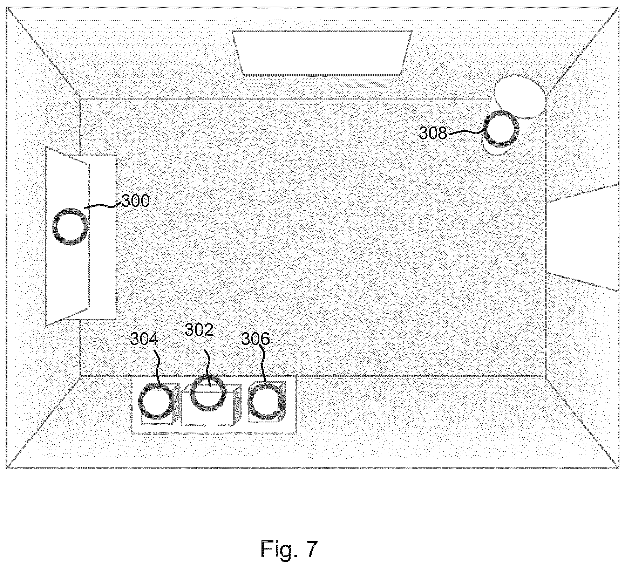

After having defined the position of three devices, any subsequent device residing substantially in a horizontal plane with said three devices has only one possible location. Similarly to the first three devices, a corresponding object in the 3D model may be searched in keyframes having the camera pose directed to said location. Finally, all devices 300 - 308 in the room have mapped to their corresponding objects in the 3D model, which is illustrated in Figure 7.

In the embodiments described herein, it must be noted that the relative positions between the uniquely identifiable devices may not be entirely accurate. Therefore according to an embodiment, when determining the keyframes in which to look for the second or third device, a predetermined area around the possible position may be used in searching for the device. For example, a circle having radius of 1 meter in every direction from the determined possible locations may be used as the search area.

According to an embodiment, there may be a reliability measurement available indicating the accuracy of the radio-based device positioning information. In this case, the size of the visual matching range may be adjusted based on the reliability information, such that when the positioning information is accurate the search may be carried out in a smaller range than when the positioning information is inaccurate. The reliability may be based on, for example, at least one standard deviation of the received signal strength indicator (RSSI) during a certain measurement window, such that the larger the standard deviation of RSSI, the less reliable the measurement is considered to be and the larger range is applied.

As explained in some embodiments, it is possible that the image matching process does not find a device when searching through the images or keyframes. In such cases, another device is chosen to be searched for and the search is repeated.

In general, reference images for visual matching may obtained from various sources. For example, reference images may be easily obtained via Web searches. The reference images may reside in a backend service cloud, which may maintain a database of product images for this purpose. Server(s) of the cloud may store a variety of device images in a compact format, and the images may be downloaded to be used for matching, e.g. as on-demand basis for each region or customer.

Alternatively or in addition, the device images may be fetched from online sources such as various web stores or Wikipedia, based on device listing info provided by the user, obtained from his purchase history, or obtained as a result of radio neighborhood scanning, or using open standards such as DLNA. For example, radio scanning may return device names and types which can then be used to search for device images. According to an embodiment, the devices themselves may provide the images or links to the images.

If any device ID (serial number, name, type etc.) is known, a query for the image may be performed based on the ID from the database. The database may be provided e.g. by a retailer selling the device and maintaining images of all products sold. For a particular device, one or more images may be used to perform image matching on the key frames of the video feed. If no exact any device ID is known or no exact model corresponding to the known device ID is available, a generic device category model for the device, generated of plurality of images for this device category, may be provided. Even such a generic model may avoid performing matching against an extensive amount of device images.

According to an embodiment, the process of searching the devices may utilize information on typical device configurations. This means typical layouts how devices may be located around a room or an apartment, and also which devices typically are located in close proximity to each other. For example, if a TV set has been aligned to the 3D model and the system needs to align a hifi set or a pair of loudspeakers to the model, it makes sense to perform the search near the location of the TV set since the TV set may often be located close to the hifi set and the loudspeakers. Correspondingly, if a refrigerator has been aligned with the model, it makes sense to perform a search for further kitchen-related gadgets such as toasters, microwave ovens, coffee makers or blenders from the same region as the refrigerators as many of these gadgets are typically located in the kitchen area.

The above information may be used in prioritizing the order of devices to be matched, for example, by performing the matching of related equipment in sequence, or in limiting the search range in addition to the radio-based positioning information. In this case, instead of limits based on relative positioning data, more relaxed prior information is applied which indicates probabilities to find certain types of devices close to each other.

Another example includes proximity to electricity sockets. If the system detects or otherwise knows one or more positions of electric sockets, it may attempt to locate devices within their proximity.

The information of typical layouts and device co-occurrence, i.e. which devices are typically proximate to each other, may be preprogrammed to the system. Alternatively, the system may learn this information over time as it is used to analyze different homes and the information of previously found device configurations and co-existence may be used to improve results for future analyses.

In the embodiments, any suitable positioning method may be used, although radio based positioning is typically most feasible. In some cases, one or more of the devices may be positioned using radio based data, while the remaining devices may then be positioned on the basis of one of the radio positioned devices. For example, visual localization methods may allow a camera enabled device to position another device on the basis of a known location of one of the radio positioned devices. Alternatively, some devices may be able to measure pairwise distances between themselves, e.g. a loudspeaker system may use a time-difference-of-arrival technique for measuring the distance between loudspeakers. In the case of audio and microphone equipped devices, audio self-localization methods may be used to position some of the devices.

In general, one or more subgroups of devices may be positioned with regard of each other. The embodiments described herein do not necessarily require all devices to have relative positioning data to each other. In the case of several subgroups of positioned devices, the embodiments may be performed for each subgroup of devices.

A skilled man appreciates that any of the embodiments described above may be implemented as a combination with one or more of the other embodiments, unless there is explicitly or implicitly stated that certain embodiments are only alternatives to each other.

The various embodiments may provide advantages over the state of the art. For example, the embodiments may enable to create interactive 3D models of spaces, which allow interacting with the devices in the space. Moreover, the amount of required visual matching is limited by the use of relative device positioning data. At the same, the robustness of the matching is improved due to the additional constraints posed by the relative positioning data, for example compared to unrestricted visual matching.

In general, the various embodiments of the invention may be implemented in hardware or special purpose circuits, software, logic or any combination thereof. For example, some aspects may be implemented in hardware, while other aspects may be implemented in firmware or software which may be executed by a controller, microprocessor or other computing device, although the invention is not limited thereto. While various aspects of the invention may be illustrated and described as block diagrams, flow charts, or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

The embodiments of this invention may be implemented by computer software executable by a data processor of the mobile device, such as in the processor entity, or by hardware, or by a combination of software and hardware. Further in this regard it should be noted that any blocks of the logic flow as in the Figures may represent program steps, or interconnected logic circuits, blocks and functions, or a combination of program steps and logic circuits, blocks and functions. The software may be stored on such physical media as memory chips, or memory blocks implemented within the processor, magnetic media such as hard disk or floppy disks, and optical media such as for example DVD and the data variants thereof, or CD.

The memory may be of any type suitable to the local technical environment and may be implemented using any suitable data storage technology, such as semiconductor based memory devices, magnetic memory devices and systems, optical memory devices and systems, fixed memory and removable memory. The data processors may be of any type suitable to the local technical environment, and may include one or more of general purpose computers, special purpose computers, microprocessors, digital signal processors (DSPs) and processors based on multi core processor architecture, as non-limiting examples.

Embodiments of the inventions may be practiced in various components such as integrated circuit modules. The design of integrated circuits is by and large a highly automated process. Complex and powerful software tools are available for converting a logic level design into a semiconductor circuit design ready to be etched and formed on a semiconductor substrate.

Programs, such as those provided by Synopsys, Inc. of Mountain View, California and Cadence Design, of San Jose, California automatically route conductors and locate components on a semiconductor chip using well established rules of design as well as libraries of pre stored design modules. Once the design for a semiconductor circuit has been completed, the resultant design, in a standardized electronic format (e.g., Opus, GDSII, or the like) may be transmitted to a semiconductor fabrication facility or "fab" for fabrication.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention.

## Claims

1. A method comprising:
obtaining a three-dimensional (3D) model of a space;
obtaining relative positions of a plurality of uniquely identifiable devices in said space;
mapping a first uniquely identifiable device to a first visually matching object in the 3D model;
selecting a second uniquely identifiable device;
determining possible locations of the second uniquely identifiable device in said space on the basis of the relative distance between the first and second uniquely identifiable device; and
mapping the second uniquely identifiable device to a second visually matching object in the 3D model, said second object locating in one of said possible locations.

2. A method according to claim 1, further comprising
selecting a third uniquely identifiable device;
determining possible locations of the third uniquely identifiable device in said space on the basis of the relative distances between the first, second and third uniquely identifiable device; and
mapping the third uniquely identifiable device to a third visually matching object in the 3D model, said third object locating in one of said possible locations.

3. A method according to claim 2, wherein said relative positions of the plurality of uniquely identifiable devices are determined in a substantially two-dimensional (2D) plane, wherein possible locations of the third uniquely identifiable device in said space comprises two possible locations, the method further comprising
selecting one of said two possible locations mapping the third uniquely identifiable device to the third object in the 3D model.

4. A method according to claim 2 or 3, further comprising
mapping any subsequent uniquely identifiable device to a visually matching object in the 3D model on the basis of the relative distances of said subsequent uniquely identifiable device to the first, second and third uniquely identifiable device.

5. A method according to any preceding claim, wherein obtaining the 3D model of the space comprises
capturing a plurality of images or video frames about the space;
and
generating a 3D point cloud describing shapes of a plurality of objects in the space.

6. A method according to any preceding claim, wherein said uniquely identifiable devices are provided with a radio transmitter and a unique identification, wherein obtaining relative positions of the uniquely identifiable devices comprises determining said relative positions on the basis of radio signal strengths of the devices.

7. A method according to claim 5 or 6, further comprising
selecting the first uniquely identifiable device from said images or video frames using an object recognition algorithm, wherein the selecting is performed on the basis of distinctiveness of volume or visual characteristics of the device.

8. A method according to claim 7, further comprising
obtaining the unique identification of the first device; and
determining properties of the first device from a server comprising device parameters associated with the unique identification.

9. A method according to any of claims 5 - 8, further comprising
performing a visual object recognition process on a subset of said plurality of images or video frames for finding the first device; and
mapping the position of the first device to the 3D model based on a camera pose of one or more images or video frames where the first device was found.

10. A method according to any of claims 7 - 9, wherein after selecting the second, and respectively the third, uniquely identifiable device and determining their possible locations, carrying out any of the steps in claims 7 to 9 for the second, and respectively, for the third uniquely identifiable device.

11. An apparatus comprising:
means for obtaining a three-dimensional (3D) model of a space;
means for obtaining relative positions of a plurality of uniquely identifiable devices in space;
means for mapping a first uniquely identifiable device to a first visually matching object in the 3D model;
means for selecting a second uniquely identifiable device;
means for determining possible locations of the second uniquely identifiable device in said space on the basis of the relative distance between the first and second uniquely identifiable device; and
means for mapping the second uniquely identifiable device to a second visually matching object in the 3D model, said second object locating in one of said possible locations.

12. An apparatus according to claim 11, further comprising
means for performing the method according to at least one of claims 2 - 10.

13. A computer program embodied on a non-transitory computer readable medium, the
computer program comprising instructions causing, when executed on at least one processor, at least the apparatus of claims 11 or 12 to:
perform a method according to at least one of claims 1 - 10.

## Patentansprüche

1. Verfahren, das Folgendes umfasst:
Erhalten eines dreidimensionalen (3D) Modells eines Raums;
Erhalten von relativen Positionen von mehreren eindeutig identifizierbaren Vorrichtungen in dem Raum;
Zuordnen einer ersten eindeutig identifizierbaren Vorrichtung zu einem ersten visuell übereinstimmenden Objekt in dem 3D-Modell;
Auswählen einer zweiten eindeutig identifizierbaren Vorrichtung;
Bestimmen von möglichen Orten der zweiten eindeutig identifizierbaren Vorrichtung in dem Raum auf der Basis des relativen Abstands zwischen der ersten und der zweiten eindeutig identifizierbaren Vorrichtung und
Zuordnen der zweiten eindeutig identifizierbaren Vorrichtung zu einem zweiten visuell übereinstimmenden Objekt in dem 3D-Modell, wobei sich das zweite Objekt an einem der möglichen Orte befindet.

2. Verfahren nach Anspruch 1, das ferner Folgendes umfasst:
Auswählen einer dritten eindeutig identifizierbaren Vorrichtung;
Bestimmen von möglichen Orten der dritten eindeutig identifizierbaren Vorrichtung in dem Raum auf der Basis der relativen Abstände zwischen der ersten, der zweiten und der dritten eindeutig identifizierbaren Vorrichtung und
Zuordnen der dritten eindeutig identifizierbaren Vorrichtung zu einem dritten visuell übereinstimmenden Objekt in dem 3D-Modell, wobei sich das dritte Objekt an einem der möglichen Orte befindet.

3. Verfahren nach Anspruch 2, wobei die relativen Positionen der mehreren eindeutig identifizierbaren Vorrichtungen in einer im Wesentlichen zweidimensionalen (2D) Ebene bestimmt werden, wobei mögliche Orte der dritten eindeutig identifizierbaren Vorrichtung in dem Raum zwei mögliche Orte umfassen, wobei das Verfahren ferner Folgendes umfasst:
Auswählen von einem der zwei möglichen Orte, der die dritte eindeutig identifizierbare Vorrichtung dem dritten Objekt in dem 3D-Modell zuordnet.

4. Verfahren nach Anspruch 2 oder 3, das ferner Folgendes umfasst:
Zuordnen einer nachfolgenden eindeutig identifizierbaren Vorrichtung zu einem visuell übereinstimmenden Objekt in dem 3D-Modell auf der Basis der relativen Abstände der nachfolgenden eindeutig identifizierbaren Vorrichtung zu der ersten, zweiten und dritten eindeutig identifizierbaren Vorrichtung.

5. Verfahren nach einem der vorhergehenden Ansprüche, wobei das Erhalten des 3D-Modells in dem Raum Folgendes umfasst:
Aufnehmen von mehreren Bildern oder Videoeinzelbildern von dem Raum und
Erzeugen einer 3D-Punktwolke, die Formen von mehreren Objekten in dem Raum beschreibt.

6. Verfahren nach einem der vorhergehenden Ansprüche, wobei die eindeutig identifizierbaren Vorrichtungen mit einem Funksender und einer eindeutigen Kennung versehen sind, wobei das Erhalten von relativen Positionen der eindeutig identifizierbaren Vorrichtungen das Bestimmen der relativen Positionen auf der Basis von Funksignalstärken der Vorrichtungen umfasst.

7. Verfahren nach Anspruch 5 oder 6, das ferner Folgendes umfasst:
Auswählen der ersten eindeutig identifizierbaren Vorrichtung aus den Bildern oder Videoeinzelbildern unter Verwendung eines Objekterkennungsalgorithmus, wobei das Auswählen auf der Basis der Einzigartigkeit von Volumen oder visuellen Charakteristiken der Vorrichtung durchgeführt wird.

8. Verfahren nach Anspruch 7, das ferner Folgendes umfasst:
Erhalten der eindeutigen Kennung der ersten Vorrichtung und
Bestimmen von Eigenschaften der ersten Vorrichtung von einem Server, der Vorrichtungsparameter umfasst, die der eindeutigen Kennung zugeordnet sind.

9. Verfahren nach einem der Ansprüche 5-8, das ferner Folgendes umfasst:
Durchführen eines visuellen Objekterkennungsprozesses auf einer Teilmenge der mehreren Bilder und Videoeinzelbilder zum Auffinden der ersten Vorrichtung und
Zuordnen der Position der ersten Vorrichtung zu dem 3D-Modell auf der Grundlage einer Kamerastellung von einem oder mehreren Bildern oder Videoeinzelbildern, auf denen die erste Vorrichtung gefunden wurde.

10. Verfahren nach einem der Ansprüche 7-9, wobei nach dem Auswählen der zweiten bzw. der dritten eindeutig identifizierbaren Vorrichtung und dem Bestimmen ihrer möglichen Orte einer der Schritte in den Ansprüchen 7 bis 9 für die zweite bzw. für die dritte eindeutig identifizierbare Vorrichtung ausgeführt wird.

11. Einrichtung, die Folgendes umfasst:
Mittel zum Erhalten eines dreidimensionalen (3D) Modells eines Raums;
Mittel zum Erhalten von relativen Positionen von mehreren eindeutig identifizierbaren Vorrichtungen in dem Raum;
Mittel zum Zuordnen einer ersten eindeutig identifizierbaren Vorrichtung zu einem ersten visuell übereinstimmenden Objekt in dem 3D-Modell;
Mittel zum Auswählen einer zweiten eindeutig identifizierbaren Vorrichtung;
Mittel zum Bestimmen von möglichen Orten der zweiten eindeutig identifizierbaren Vorrichtung in dem Raum auf der Basis des relativen Abstands zwischen der ersten und der zweiten eindeutig identifizierbaren Vorrichtung und
Mittel zum Zuordnen der zweiten eindeutig identifizierbaren Vorrichtung zu einem zweiten visuell übereinstimmenden Objekt in dem 3D-Modell, wobei sich das zweite Objekt an einem der möglichen Orte befindet.

12. Einrichtung nach Anspruch 11, das ferner Folgendes umfasst:
Mittel zum Durchführen des Verfahrens nach mindestens einem der Ansprüche 2-10.

13. Computerprogramm, das auf einem nichttransitorischen computerlesbaren Medium enthalten ist, wobei das Computerprogramm Anweisungen umfasst, die dann, wenn sie auf mindestens einem Prozessor ausgeführt werden, bewirken, dass die Einrichtung nach Anspruch 11 oder 12:
ein Verfahren nach mindestens einem der Ansprüche 1 bis 10 durchführt.

## Revendications

1. Procédé comprenant :
l'obtention d'un modèle tridimensionnel (3D) d'un espace ;
l'obtention de positions relatives d'une pluralité de dispositifs à identité propre dans ledit espace ;
la mise en correspondance d'un premier dispositif à identité propre avec un premier objet concordant visuellement dans le modèle 3D ;
la sélection d'un deuxième dispositif à identité propre ;
la détermination d'emplacements possibles du deuxième dispositif à identité propre dans ledit espace en fonction de la distance relative entre les premier et deuxième dispositifs à identité propre ; et
la mise en correspondance du deuxième dispositif à identité propre avec un deuxième objet concordant visuellement dans le modèle 3D, ledit deuxième objet étant situé à un desdits emplacements possibles.

2. Procédé selon la revendication 1, comprenant en outre
la sélection d'un troisième dispositif à identité propre ;
la détermination d'emplacements possibles du troisième dispositif à identité propre dans ledit espace en fonction des distances relatives entre les premier, deuxième et troisième dispositifs à identité propre ; et
la mise en correspondance du troisième dispositif à identité propre avec un troisième objet concordant visuellement dans le modèle 3D, ledit troisième objet étant situé à un desdits emplacements possibles.

3. Procédé selon la revendication 2, dans lequel lesdites positions relatives de la pluralité de dispositifs à identité propre sont déterminées dans un plan sensiblement bidimensionnel (2D), dans lequel des emplacements possibles du troisième dispositif à identité propre dans ledit espace comprennent deux emplacements possibles, le procédé comprenant en outre
la sélection d'un desdits deux emplacements possibles mettant en correspondance le troisième dispositif à identité propre avec le troisième objet dans le modèle 3D.

4. Procédé selon la revendication 2 ou 3, comprenant en outre
la mise en correspondance de n'importe quel dispositif à identité propre suivant avec un objet concordant visuellement dans le modèle 3D en fonction des distances relatives dudit dispositif à identité propre suivant par rapport aux premier, deuxième et troisième dispositifs à identité propre.

5. Procédé selon n'importe quelle revendication précédente, dans lequel l'obtention du modèle 3D de l'espace comprend
la capture d'une pluralité d'images ou de trames vidéo relatives à l'espace ; et
la génération d'un nuage de points 3D décrivant des formes d'une pluralité d'objets dans l'espace.

6. Procédé selon n'importe quelle revendication précédente, dans lequel lesdits dispositifs à identité propre sont dotés d'un émetteur radio et d'une identification unique, dans lequel l'obtention de positions relatives des dispositifs à identité propre comprend la détermination desdites positions relatives en fonction de forces de signaux radio des dispositifs.

7. Procédé selon la revendication 5 ou 6, comprenant en outre
la sélection du premier dispositif à identité propre à partir desdites images ou trames vidéo à l'aide d'un algorithme de reconnaissance d'objets, dans lequel la sélection est réalisée en fonction de la nature distincte de caractéristiques sonores ou visuelles des dispositifs.

8. Procédé selon la revendication 7, comprenant en outre
l'obtention de l'identité propre du premier dispositif ; et
la détermination de propriétés du premier dispositif à partir d'un serveur comprenant des paramètres de dispositif associés à l'identité propre.

9. Procédé selon l'une quelconque des revendications 5 à 8, comprenant en outre
l'exécution d'un processus de reconnaissance visuelle d'objet sur un sous-ensemble de ladite pluralité d'images ou de trames vidéo pour trouver le premier dispositif ; et
la mise en correspondance de la position du premier dispositif avec le modèle 3D en fonction d'une pose de caméra d'une ou de plusieurs images ou trames vidéo où le premier dispositif a été trouvé.

10. Procédé selon l'une quelconque des revendications 7 à 9, comprenant après la sélection du deuxième, et respectivement du troisième, dispositif à identité propre et la détermination de leurs emplacements possibles, l'exécution de n'importe laquelle des étapes des revendications 7 à 9 pour le deuxième, et respectivement le troisième, dispositif à identité propre.

11. Appareil comprenant :
un moyen d'obtention d'un modèle tridimensionnel (3D) d'un espace ;
un moyen d'obtention de positions relatives d'une pluralité de dispositifs à identité propre dans l'espace ;
un moyen de mise en correspondance d'un premier dispositif à identité propre avec un premier objet concordant visuellement dans le modèle 3D ;
un moyen de sélection d'un deuxième dispositif à identité propre ;
un moyen de détermination d'emplacements possibles du deuxième dispositif à identité propre dans ledit espace en fonction de la distance relative entre les premier et deuxième dispositifs à identité propre ; et
un moyen de mise en correspondance du deuxième dispositif à identité propre avec un deuxième objet concordant visuellement dans le modèle 3D, ledit deuxième objet étant situé à un desdits emplacements possibles.

12. Appareil selon la revendication 11, comprenant en outre
un moyen de réalisation du procédé selon au moins une des revendications 2 à 10.

13. Programme informatique mis en œuvre sur un support non transitoire lisible par ordinateur, le programme informatique comprenant des instructions qui, à leur exécution sur au moins un processeur, amènent au moins l'appareil des revendications 11 ou 12 à :
réaliser un procédé selon au moins une des revendications 1 à 10.
